# EUROPEAN PATENT APPLICATION

(11) **EP 4 488 314 A1**
(43) Date of publication of application: **08.01.2025**
(21) Application number: 23759976.6
(22) Date of filing: 21.02.2023
(51) Int. Cl.: C08G 59/62, C08K 3/013, C08L 63/00, H01L 23/29, H01L 23/31

(54) **SEALING RESIN COMPOSITION AND SEMICONDUCTOR DEVICE**

(30) Priority: 28.02.2022 JP 2022029262
(71) Applicant: Sumitomo Bakelite Co.Ltd., Shinagawa-ku Tokyo 140-0002 (JP)
(72) Inventor: IWAI, Masahiro, Tokyo 140-0002 (JP); TANAKA, Yusuke, Tokyo 140-0002 (JP)
(74) Representative: Müller-Boré & Partner Patentanwälte PartG mbB
(86) International application number: PCT/JP2023/006237
(87) International publication number: WO 2023/162975

(57) **Abstract**

The sealing resin composition of the present invention contains an epoxy resin (A) and a curing agent (B) including a phenolic curing agent obtained from a plant-derived raw material.

## Description

### TECHNICAL FIELD

The present invention relates to a sealing resin composition and a semiconductor device.

### BACKGROUND ART

As a material for sealing a semiconductor package or the like, a thermosetting resin composition (sealing resin composition) has been known.

For example, Patent Document 1 discloses a sealing resin used for collectively sealing, in an electronic device used for an automobile, such as an engine control unit or an automatic transmission controller unit, an electronic component provided in the electronic device, a substrate on which the electronic component is mounted, and a terminal connected to the substrate.

In recent years, a resin using fossil resources has been concerned about the influence on the global environment, such as resource depletion and carbon dioxide emission, and the development of materials has also been studied to utilize biomass resources such as plant-derived raw materials.

### RELATED DOCUMENT

### PATENT DOCUMENT

[Patent Document 1] International Publication No. WO2017/056728

### SUMMARY OF THE INVENTION

### TECHNICAL PROBLEM

From the viewpoint of effectively using non-fossil resources, it is preferable to obtain a composition having a high degree of biomass, by using a resin or the like obtained from a plant-derived raw material. However, in a case where the degree of biomass is increased, physical properties such as fluidity, curability, and electrical reliability may be deteriorated.

### SOLUTION TO PROBLEM

The present inventors have found that, by using a phenolic curing agent obtained from a plant-derived raw material with a predetermined blending, it is possible to improve these physical properties while increasing the degree of biomass, and have completed the present invention.

That is, the present invention can be shown below.

[1] A sealing resin composition containing:
   (A) an epoxy resin; and
   (B) a curing agent including a phenolic curing agent obtained from a plant-derived raw material.
[2] The sealing resin composition according to [1],
   in which the phenolic curing agent obtained from a plant-derived raw material is a biomass-modified phenol resin which is modified with unsaturated carbon chain-containing phenols derived from a plant raw material.
[3] The sealing resin composition according to [1] or [2],
   in which the curing agent (B) includes a phenolic curing agent obtained from a petroleum-derived raw material.
[4] The sealing resin composition according to any one of [1] to [3],
   in which the epoxy resin (A) includes an epoxy resin obtained from a petroleum-derived raw material.
[5] The sealing resin composition according to any one of [1] to [4],
   in which the epoxy resin (A) includes an epoxy resin obtained by epoxidizing phenols derived from a plant-derived raw material.
[6] The sealing resin composition according to any one of [1] to [5], further containing:
   a curing accelerator (C).
[7] The sealing resin composition according to any one of [1] to [6], further containing:
   an inorganic filler (D).
[8] The sealing resin composition according to any one of [1] to [7],
   in which a spiral flow length measured under the following conditions is 100 cm or more and 250 cm or less,
   (conditions)
   a flow length measured by injecting the sealing resin composition into a spiral flow measurement mold according to EMMI-1-66 under conditions of a mold temperature of 175°C, an injection pressure of 6.9 MPa, and a curing time of 120 seconds is defined as the spiral flow length.
[9] The sealing resin composition according to any one of [1] to [8],
   in which a gel time at 175°C is 10 seconds or more and 60 seconds or less.
[10] A cured product of the sealing resin composition according to any one of [1] to [9].
[11] The cured product according to [10],
   in which a degree of biomass is 5% or more and 95% or less.
[12] A semiconductor device including:
   a semiconductor element; and
   a sealing material which consists of the cured product according to [10] or [11] and seals the semiconductor element.

### ADVANTAGEOUS EFFECTS OF INVENTION

With the sealing resin composition according to the aspect of the present invention, by using a plant-derived raw material, it is possible to provide a sealing material which is friendly to the global environment, and has excellent practicality such as fluidity, curability, and electrical reliability.

### BRIEF DESCRIPTION OF THE DRAWINGS

Fig. 1 is a cross-sectional view showing a configuration of a semiconductor device according to an embodiment.
Fig. 2 is a cross-sectional view showing a configuration of a semiconductor device according to an embodiment.

### DESCRIPTION OF EMBODIMENTS

Hereinafter, embodiments of the present invention will be described with reference to the drawings. In all drawings, the same constituents are designated by the same reference numerals, and description thereof will not be repeated. In addition, for example, "1 to 10" represents from "equal to or more than 1" to "equal to or less than 10" unless otherwise specified.

The sealing resin composition according to the present embodiment contains an epoxy resin (A) and a curing agent (B) including a phenolic curing agent (B1) obtained from a plant-derived raw material.

In the present embodiment, the plant-derived phenolic curing agent (B1) and a plant-derived epoxy resin (A2) described later, which is included in the epoxy resin (A), can be obtained from plant-derived phenols.

### [Plant-derived phenols]

Specific examples of the plant-derived phenols include phenol (hydroxybenzene); benzene diols (dihydroxybenzenes) such as catechol, resorcinol, and hydroquinone;
benzene triols (trihydroxybenzene) such as hydroxyquinol, phloroglucinol, and pyrogallol;
unsaturated carbon chain-containing phenols such as cashew oil and cardanol;
saturated carbon chain-containing phenols such as cardol, 2-methylcardol, and anacardic acid; and
o-cresol, m-cresol, p-cresol, 2,4-dimethylphenol, 2,6-dimethylphenol, 2,3,6-trimethylphenol, 2,4,6-trimethylphenol, 5-isopropyl-2-methylphenol, 4-isopropylphenol, 4-cyclohexylphenol, 4-phenylphenol, 3-pentadecylphenol, 3-pentadecylphenol monoene, 3-pentadecylphenol diene, 3-pentadecylphenol triene, catechol monoalkyl ether, hydroquinone monoalkyl ether, 4-hydroxyphenyl acetic acid methyl, 1-naphthol, 2-naphthol, bisphenol A, 2,6-dimethoxyphenol, lignin, 4,4'-biphenol, 3,3',5,5'-tetramethylbiphenyl-4,4'-diol, and the like.

In addition, examples of a derivative include a salt, a hydrate, and a solvate.

A heterocyclic compound may include a compound derived from non-biomass and other components as an impurity, in addition to the main component.

Examples of a method for producing the plant-derived phenols include a method of obtaining the plant-derived phenols, for example, through a step 1 of obtaining a raw material containing hydroxybenzoic acids from mixed sugars contained in a plant, and then a step 2 of decarboxylating the hydroxybenzoic acids by a biological reaction or a chemical reaction.

Examples of a method of the step 1 include a method described in Biotechnology and Bioengineering, Vol. 76, p. 376, 2001 and a method described in International Publication No. WO2015/156271.

Examples of a method of the step 2 include International Publication No. WO2012/063860 as a biological reaction and a decarboxylation reaction with an acidic compound as a chemical reaction.

### [Epoxy resin (A)]

The epoxy resin (A) is a compound having two or more epoxy groups in one molecule, and may be a monomer, an oligomer, or a polymer.

Specifically, the epoxy resin (A) is one or two or more selected from the group consisting of crystalline epoxy resins such as a biphenyl-type epoxy resin, a bisphenol-type epoxy resin, and a stilbene-type epoxy resin; a novolac-type epoxy resins such as a phenol novolac-type epoxy resin and a cresol novolac-type epoxy resin; polyfunctional epoxy resins such as a trisphenylmethane-type epoxy resin and an alkyl-modified triphenol methane-type epoxy resin; phenol aralkyl-type epoxy resins such as a phenylene skeleton-containing phenol aralkyl-type epoxy resin and a biphenylene skeleton-containing phenol aralkyl-type epoxy resin; naphthol-type epoxy resins such as a dihydroxynaphthalene-type epoxy resin and an epoxy resin obtained by glycidyl etherification of a dimer of dihydroxynaphthalene; triazine nuclei-containing epoxy resins such as triglycidyl isocyanurate and monoallyl diglycidyl isocyanurate; and bridged cyclic hydrocarbon compound-modified phenol-type epoxy resins such as a dicyclopentadiene-modified phenol-type epoxy resin.

From the viewpoint of improving the adhesiveness to the metal member, the epoxy resin (A) is preferably one or two or more selected from the group consisting of a trisphenylmethane-type epoxy resin, a biphenyl aralkyl-type polyfunctional epoxy resin, an ortho-cresol-type bifunctional epoxy resin, a biphenyl-type bifunctional epoxy resin, and a bisphenol-type bifunctional epoxy resin.

From the same viewpoint, the epoxy resin (A) is preferably one or two or more selected from the group consisting of a tris(hydroxyphenyl)methane-type epoxy resin, a biphenylene skeleton-containing phenol aralkyl-type epoxy resin, an ortho-cresol novolac-type epoxy resin, and a 3,3',5,5'-tetramethylbiphenylglycidyl ether-type epoxy resin.

The epoxy resin (A) can include an epoxy resin (A1) obtained from a petroleum-derived raw material. Examples of the epoxy resin (A1) include the above-described epoxy resins.

In the present embodiment, from the viewpoint of improving the degree of biomass, it is preferable to include an epoxy resin (A2) obtained by epoxidizing a phenol derived from a plant-derived raw material. The plant-derived epoxy resin (A2) is obtained, for example, by a step of reacting a compound having a plant-derived phenol hydroxyl group, such as the above-described plant-derived phenols and the plant-derived phenolic curing agent (B1), with epichlorohydrin or the like to substitute the phenol hydroxyl group with a phenol glycidyl ether group.

From the viewpoint of obtaining suitable fluidity during molding and improving fillability and moldability, the content of the epoxy resin (A) in the sealing resin composition is preferably 2% by mass or more, more preferably 3% by mass or more, and still more preferably 4% by mass or more with respect to the entire sealing resin composition.

In addition, from the viewpoint of improving reliability of a device obtained by using the sealing resin composition, the content of the epoxy resin (A) in the sealing resin composition is preferably 40% by mass or less, more preferably 30% by mass or less, still more preferably 20% by mass or less, and even more preferably 10% by mass or less with respect to the entire sealing resin composition.

In a case where the epoxy resin (A) includes the epoxy resin (A1) and the plant-derived epoxy resin (A2), a ratio (A1:A2) of the epoxy resin (A1) and the epoxy resin (A2) can be preferably 10:90 to 90:10 and more preferably 20:80 to 80:20.

### [Curing agent (B)]

The curing agent (B) includes a phenolic curing agent (B1) obtained from a plant-derived raw material.

The plant-derived phenolic curing agent (B1) is obtained, for example, by a step of reacting the above-described plant-derived phenols with aldehydes derived from plant or petroleum in the presence of an acidic catalyst.

Examples of the plant-derived phenolic curing agent (B1) include a phenol novolac resin, a cresol novolac resin, an aromatic hydrocarbon formaldehyde resin-modified phenol resin, a dicyclopentadiene-phenol addition-type resin, a phenol aralkyl resin, a biphenyl skeleton-containing phenol aralkyl resin, a naphthol aralkyl resin, a trimethylolmethane resin, a tetraphenylethane resin, a naphthol novolac resin, a naphthol-phenol copolycondensed novolac resin, a naphthol-cresol copolycondensed novolac resin, a biphenyl-modified phenol resin (polyhydric phenol compound in which phenol nuclei are linked by a bismethylene group), a biphenyl-modified naphthol resin (polyhydric naphthol compound in which phenol nuclei are linked by a bismethylene group), an aminotriazine-modified phenol resin (polyhydric phenol compound in which phenol nuclei are linked by melamine, benzo guanamine, or the like), a trisphenol methane type phenol resin, and a biomass-modified phenol resin. In the present embodiment, it is preferable to use a biomass-modified phenol resin as the plant-derived phenolic curing agent (B1).

### (Biomass-modified phenol resin)

As the biomass-modified phenol resin, a known biomass-modified phenol resin can be used as long as the effects of the present invention are exhibited, and biomass-modified phenol resin which is modified with unsaturated carbon chain-containing phenols derived from a plant raw material is preferable.

The above-described biomass-modified phenol resin can be obtained, for example, by a step of reacting a biomass derivative, phenols, and aldehydes. The biomass derivative can be obtained, for example, by an addition reaction step of adding phenols to a double bond of an unsaturated carbon chain of unsaturated carbon chain-containing phenols derived from a plant raw material.

The above-described plant raw material is not particularly limited as long as it is unsaturated carbon chain-containing phenols, and examples thereof include plant-derived unsaturated carboxylic acids such as cinnamic acid, cinnamaldehyde, caffeic acid, ferulic acid, coumaric acid, and derivatives thereof; and plant-derived phenolic hydroxyl group and unsaturated alkyl group-containing phenols such as cashew nut shell liquid (cashew oil), for example, cardanol, cardol, methylcardol, anacardic acid, and the like, a urushiol extract, for example, urushiol, laccol, and thitsiol, and purified products thereof. These may be used alone or in combination of two or more thereof.

In the present embodiment, by using the unsaturated carbon chain-containing phenols as the plant raw material, a biomass modification rate in the biomass-modified phenol resin can be increased, and heat resistance of the cured product can be improved. In addition, by using the phenolic hydroxyl group and unsaturated alkyl group-containing phenols, it is possible to realize a biomass-modified phenol resin having a high biomass introduction rate and excellent reactivity. In addition, since the biomass-modified phenol resin has no easily decomposable functional group such as an ester group, unlike other animal and vegetable oils and fats, a molded object composed of a cured product of the biomass-modified phenol resin can be excellent in heat resistance.

From the viewpoint of cost, a plant raw material containing cashew oil can be used. The above-described cashew oil is an oily liquid contained in a shell of cashew nut, and includes anacardic acid, cardol, 2-methylcardol, cardanol, and the like. Among these, the above-described cashew oil can include one or more selected from the group consisting of cardanol, cardol, and 2-methylcardol. In addition, a purified product of the cashew oil, such as cardanol, may be used. These may be used alone or in combination of two or more thereof. As a result, the above-described biomass-modified phenol resin can include a cashew-modified phenol resin.

In addition, the above-described phenolic hydroxyl group and unsaturated alkyl group-containing phenols include, for example, a phenol compound represented by General Formula (1). These may be used alone or in combination of two or more thereof.

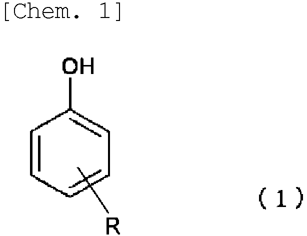

In Formula (1), R represents a linear unsaturated hydrocarbon group having 10 or more carbon atoms. However, a hydrogen atom bonded to a benzene ring having a phenolic hydroxyl group may be substituted with a substituent. In addition, R may be at any of an ortho-position, a meta-position, or a para-position, and may be one or more, two or more, or three or more.

In addition, R in Formula (1) represents a linear unsaturated hydrocarbon group having 10 or more carbon atoms; and a linear unsaturated hydrocarbon group having 10 to 20 carbon atoms is preferable, a linear unsaturated hydrocarbon group having 12 to 20 carbon atoms is more preferable, and a linear unsaturated hydrocarbon group having 12 to 18 carbon atoms is still more preferable. In a case where the number of carbon atoms in the linear unsaturated hydrocarbon group is equal to or less than the upper limit value of the above-described range, the phenol compound is easily diluted with an organic solvent. On the other hand, in a case where the number of carbon atoms in the linear unsaturated hydrocarbon group is equal to or more than the above-described lower limit value, flexibility is likely to be improved. It is sufficient that the linear unsaturated hydrocarbon group has one or more double bonds, and it may be two double bonds or three double bonds.

The substituent which substitutes the hydrogen atom bonded to the benzene ring having the phenolic hydroxyl group is not particularly limited, and examples thereof include an acetyl group, a methyl group, and a hydroxyl group.

Specific examples of the phenol compound represented by Formula (1) include 3-dodecenylphenol, 3-tridecenylphenol, 3-pentadecenylphenol, 5-tridecenylresorcinol, 5-pentadecenylresorcinol, cardanol which is a phenol having a linear unsaturated hydrocarbon group having 15 carbon atoms at the meta-position, cardol which is a phenol having a linear unsaturated hydrocarbon group having 15 carbon atoms and a hydroxyl group at the meta-position, and 2-methylcardol which is a phenol having a linear unsaturated hydrocarbon group having 15 carbon atoms and a hydroxyl group at the meta-position and a methyl group at the ortho-position. In the present embodiment, cardanol is preferably used.

The cardanol is a component contained in the shell of cashew nut, and is a compound having a structure represented by Formula (2), which consists of a phenol moiety and a linear hydrocarbon moiety having 15 carbon atoms. The cardanol has four types of unsaturated bond numbers in the linear hydrocarbon moiety R, and is usually a mixture of these four components. That is, it is a mixture of 3-pentadecylphenol, 3-pentadecylphenol monoene, 3-pentadecylphenol diene, and 3-pentadecylphenol triene, which are represented by Formula (2). A cashew oil containing the cardanol as a main component, which is obtained by extracting and purifying from a cashew nut shell liquid, can be used.

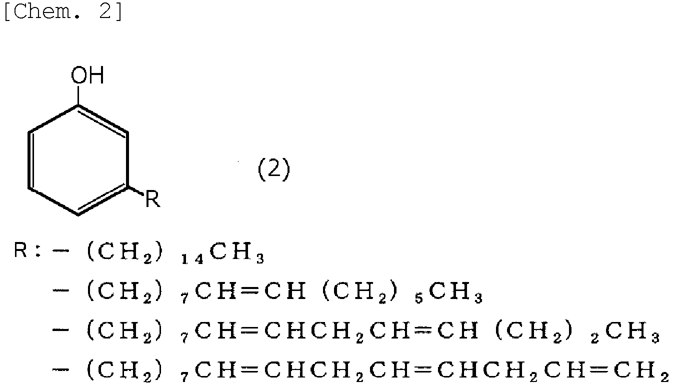

In the above-described addition reaction step, for example, by performing a heating treatment in the presence of an acidic catalyst, the phenols can be subjected to an addition reaction with a double bond of the unsaturated carbon chain of the unsaturated carbon chain-containing phenols derived from a plant raw material, to obtain a biomass derivative. As a result, double bonds of unsaturated carbon chains remaining in the unsaturated carbon chain-containing phenols can be reduced.

The acidic catalyst is not particularly limited, and examples thereof include organic carboxylic acids such as formic acid and acetic acid; organic sulfonic acids such as benzenesulfonic acid, para-toluenesulfonic acid, and methanesulfonic acid; alkyl sulfates such as dimethyl sulfate and diethyl sulfate; Lewis acid salts such as aluminum chloride, aluminum bromide, iron(II) chloride, zinc chloride, boron trifluoride, tin(II) chloride, antimony chloride, gallium chloride, and gallium bromide; and inorganic acids such as sulfuric acid. Among these, an organic sulfonic acid such as para-toluenesulfonic acid or an inorganic acid such as sulfuric acid can be used.

In addition, a reaction temperature in the above-described addition reaction step can be appropriately selected depending on the plant raw material, but for example, may be 100°C to 200°C, preferably 120°C to 180°C. A reaction time in the above-described addition reaction step is not particularly limited, and may be appropriately determined according to reaction conditions, and may be, for example, 1 hour to 8 hours.

In the method for producing the biomass derivative according to the present embodiment, the acidic catalyst may be removed by neutralization as necessary, or the acidic catalyst may remain as it is in the biomass derivative. In addition, depending on the product form after the processing, the excess unreacted phenols may be removed later, or the unreacted phenols may remain in the biomass derivative.

The phenols used in the above-described addition reaction step may have, for example, mononuclear, dinuclear or trinuclear phenol rings, and the number of phenolic hydroxyl groups may be 1 or 2 or more.

Examples of the above-described phenols include, which is not limited to these, phenol; cresols such as ortho-cresol, meta-cresol, and para-cresol; xylenols such as 2,3-xylenol, 2,4-xylenol, 2,5-xylenol, 2,6-xylenol, and 3,5-xylenol; alkylphenols such as 2,3,5-trimethylphenol, 2-ethylphenol, 4-ethylphenol, 2-isopropylphenol, 4-isopropylphenol, n-butylphenol, isobutylphenol, tert-butylphenol, hexylphenol, octylphenol, nonylphenol, phenylphenol, benzylphenol, cumylphenol, and allylphenol; naphthols such as 1-naphthol and 2-naphthol; halogenated phenols such as fluorophenol, chlorophenol, bromophenol, and iodophenol; monohydric phenol substitutes such as p-phenylphenol, aminophenol, nitrophenol, dinitrophenol, and trinitrophenol; and polyhydric phenols such as resorcinol, alkylresorcinol, pyrogallol, catechol, alkylcatechol, hydroquinone, alkylhydroquinone, phloroglucin, bisphenol A, bisphenol F, bisphenol S, dihydronaphthalene, and naphthalene. These may be used alone or in combination of two or more thereof. Among these, the phenols can include one or more selected from the group consisting of phenol, cresol, xylenol, and alkylphenol, and from the viewpoint of cost, phenol can be used.

In the present embodiment, the step of obtaining the biomass-modified phenol resin includes a step of reacting the obtained biomass derivative, phenols, and aldehydes, and as a result, a reaction solution containing a biomass-modified phenol resin obtained by reacting the biomass derivative, the phenols, and the aldehydes can be obtained.

In a case of producing the novolac-type biomass-modified phenol resin, the step of obtaining the reaction solution can be carried out under acidic conditions. In this case, an acidic catalyst such as a known organic acid and inorganic acid can be used. On the other hand, in a case of producing a resol-type biomass-modified phenol resin, the step of obtaining the reaction solution can be carried out under alkaline conditions. In this case, an alkaline catalyst can be used. Here, as an example, a method of producing a novolac-type phenol resin will be described. In this case, from the viewpoint of strength, a novolac-type biomass-modified phenol resin can be used.

The novolac-type biomass-modified phenol resin obtained using the cardanol has a structural unit represented by Formula (3).

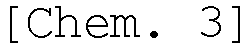

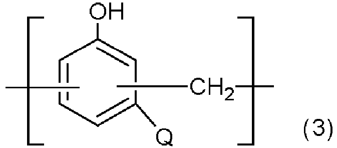

In Formula (3), Q includes a structure in which the above-described phenols are added to the double bond of the unsaturated carbon chain of R in Formula (2) described above.

The aldehydes used in the above-described step of obtaining the biomass-modified phenol resin are not particularly limited, and examples thereof include formaldehydes such as formalin and para-formaldehyde; trioxane, acetaldehyde, propionaldehyde, polyoxymethylene, chloral, hexamethylenetetramine, furfural, glyoxal, n-butylaldehyde, caproaldehyde, allylaldehyde, benzaldehyde, crotonaldehyde, acrolein, tetraoxymethylene, phenylacetaldehyde, o-tolualdehyde, and salicylaldehyde. These aldehydes may be used alone or in combination of two or more thereof. Among these, the aldehydes can include formaldehyde or acetaldehyde, and from the viewpoint of productivity and cost, formalin or para-formaldehyde can be used.

As the phenols used in the above-described step of obtaining the biomass-modified phenol resin, the phenols described in the addition reaction step above can be used. These may be used alone or in combination of two or more thereof. The phenols used in each step may be the same or different from each other.

The acidic catalyst used in the synthesis of the novolac-type biomass-modified phenol resin is not particularly limited, and examples thereof include acids such as formic acid, hydrochloric acid, sulfuric acid, diethyl sulfate, and para-toluenesulfonic acid, and metal salts such as zinc acetate, which can be used alone or in combination of two or more thereof. An amount of the acidic catalyst used is not particularly limited, but can be set to 0.1% by mass or more and 10% by mass or less with respect to the entire biomass-modified phenol resin.

As a reaction solvent in the present embodiment, water may be used, or an organic solvent may be used. A non-aqueous system such as a non-polar solvent can be used as the organic solvent. Examples of the organic solvent include alcohols, ketones, and aromatics. Examples of the alcohols include methanol, ethanol, propyl alcohol, ethylene glycol, diethylene glycol, triethylene glycol, and glycerin, examples of the ketones include acetone and methyl ethyl ketone, and examples of the aromatics include toluene and xylene. These may be used alone or in combination of two or more thereof.

In addition, a reaction temperature may be, for example, 40°C to 120°C, preferably 60°C to 110°C. A reaction time is not particularly limited, and may be appropriately determined according to the type of the starting material, the molar ratio of the formulation, the amount and type of the catalyst used, and the reaction conditions.

As a result, a reaction solution containing the biomass-modified phenol resin can be obtained.

In addition, in the present embodiment, a neutralization step of neutralizing the reaction solution may be performed.

In addition, as necessary, a step of, after the above-described reaction, removing unreacted monomers (for example, unreacted phenols) by a monomer-removing step may be added.

In addition, a dehydrating step may be performed. The dehydrating step may be carried out at the same time as the monomer-removing step. As the dehydration method, reduced pressure dehydration may be used, or normal pressure dehydration may be used. A degree of vacuum during the reduced pressure dehydration may be, for example, 110 torr or less, preferably 80 torr or less. As a result, a dehydration time can be shortened, and a stable biomass-modified phenol resin with little variation in resin characteristics can be obtained. In addition, a moisture content in the biomass-modified phenol resin can be set to 5% by weight or less by the dehydrating step. Sufficiently removing the moisture can be performed by these methods, but in order to further remove the moisture, a step of using a known moisture removing device such as a vacuum dryer and a thin film evaporator may be combined.

As a result, the biomass-modified phenol resin can be recovered and used as the plant-derived phenolic curing agent (B1).

The plant-derived phenolic curing agent (B1) contains more impurities such as ionic impurities, as compared with a petroleum-derived phenolic curing agent. It is considered that, in a case where the degree of biomass is increased due to one factor, physical properties such as fluidity, curability, and electrical reliability are deteriorated. In the present embodiment, by using the phenolic curing agent obtained from a plant-derived raw material with a predetermined blending, the degree of biomass can be increased while improving these physical properties.

The curing agent (B) may include a phenolic curing agent (B2) obtained from a petroleum-derived raw material, together with the plant-derived phenolic curing agent (B1).

Examples of the phenol curing agent (B2) include a novolac resin obtained by condensing or co-condensing phenols such as a phenol novolac resin, a cresol novolac resin, phenol, cresol, resorcinol, catechol, bisphenol A, bisphenol F, phenylphenol, aminophenol, α-naphthol, β-naphthol, and dihydroxynaphthalene with formaldehyde or ketones in the presence of an acidic catalyst; phenol aralkyl resins such as a phenol aralkyl resin having a biphenylene skeleton and a phenol aralkyl resin having a phenylene skeleton, which are synthesized from the phenols and dimethoxyparaxylene or bis(methoxymethyl)biphenyl; and a phenol resin having a trisphenylmethane skeleton. These may be used alone or in combination of two or more thereof.

In a case where the curing agent (B) includes the plant-derived phenolic curing agent (B1) and the petroleum-derived phenolic curing agent (B2), the curing agent can be used such that a degree of biomass of a cured body of the sealing resin composition according to the present embodiment is in a predetermined range (5% or more and 95% or less), and for example, the phenolic curing agent (B2) can be contained in an amount of preferably 0.5% by mass or more and 50% by mass or less, and more preferably 1% by mass or more and 20% by mass or less with respect to the total amount (100% by mass) of the curing agent (B).

In the sealing resin composition according to the present embodiment, from the viewpoint of the effect of the present invention, a blending amount of the curing agent (B) and the epoxy resin (A) is preferably a proportion in which the epoxy group in the epoxy resin is 0.8 to 1.2 equivalents with respect to 1 equivalent of the total amount of active groups in the curing agent (B). Here, the active group in the curing agent (B) refers to an arylcarbonyloxy group and a phenolic hydroxyl group, which are included in the resin structure.

In the composition according to the present embodiment, the curing agent (B) is used in an amount of preferably 0.2% by mass or more and 15% by mass or less, more preferably 0.5% by mass or more and 10% by mass or less, and still more preferably 1.0% by mass or more and 7% by mass or less with respect to the entire sealing resin composition.

In a case where the curing agent (B) is contained in the above-described range, the obtained cured product can have more excellent dielectric characteristics, and a low dielectric loss tangent can be further excellent.

### [Curing accelerator (C)]

The sealing resin composition according to the present embodiment can contain a curing accelerator (C).

As the curing accelerator (C), for example, one or two or more selected from phosphorus atom-containing compounds such as organic phosphine, tetra-substituted phosphonium compound, phosphobetaine compound, adduct of phosphine compound and quinone compound, and adduct of phosphonium compound and silane compound; nitrogen atom-containing compounds such as amidines such as 1,8-diazabicyclo[5.4.0]undecene-7, benzyldimethylamine, and 2-methylimidazole, tertiary amines, and quaternary salts of the amidines or amines; and polyhydroxynaphthalene compounds such as 2,3-dihydroxynaphthalene can be included. Among these, from the viewpoint of improving curability, it is more preferable to include a phosphorus atom-containing compound. In addition, from the viewpoint of improving balance between moldability and curability, it is more preferable to include a compound having latent property, such as tetra-substituted phosphonium compound, phosphobetaine compound, adduct of phosphine compound and quinone compound, and adduct of phosphonium compound and silane compound.

From the viewpoint of improving curing characteristics of the sealing resin composition, the content of the curing accelerator (C) in the sealing resin composition is preferably 0.01% by mass or more, more preferably 0.05% by mass or more, and still more preferably 0.1% by mass or more with respect to the entire sealing resin composition.

In addition, from the viewpoint of obtaining preferred fluidity during molding of the sealing resin composition, the content of the curing accelerator (C) in the sealing resin composition is preferably 2.0% by mass or less, more preferably 1.0% by mass or less, and still more preferably 0.5% by mass or less with respect to the entire sealing resin composition.

### [Inorganic filler (D)]

The sealing resin composition according to the present embodiment can contain an inorganic filler (D).

As the inorganic filler (D), those generally used for resin compositions for sealing a semiconductor, and the like can be used. In addition, the inorganic filler (D) may be a material which has been subjected to a surface treatment.

Specific examples of the inorganic filler (D) include silica such as fused silica, crystalline silica, and amorphous silicon dioxide; alumina; talc; titanium oxide; silicon nitride; and aluminum nitride. These inorganic fillers may be used alone or in combination of two or more.

From the viewpoint of excellent versatility, the inorganic filler (D) preferably includes silica. Examples of a shape of silica include spherical silica and crushed silica.

From the viewpoint of improving the moldability and adhesiveness, an average diameter (D₅₀) of the inorganic filler (D) is preferably 5 µm or more and more preferably 10 µm or more, and is preferably 80 µm or less, more preferably 50 µm or less, and still more preferably 40 µm or less.

Here, a particle diameter distribution of the inorganic filler (D) can be obtained by measuring the particle diameter distribution of particles on a volume basis using a commercially available laser diffraction type particle diameter distribution measuring device (for example, SALD-7000 manufactured by Shimadzu Corporation).

In addition, from the viewpoint of improving the moldability and adhesiveness, a maximum particle diameter of the inorganic filler (D) is preferably 10 µm or more and more preferably 20 µm or more, and is preferably 100 µm or less and more preferably 80 µm or less.

In addition, from the viewpoint of improving the moldability and adhesiveness, a specific surface area of the inorganic filler (D) is preferably 1 m²/g or more and more preferably 3 m²/g or more, and is preferably 20 m²/g or less and more preferably 10 m²/g or less.

From the viewpoint of improving a low hygroscopicity and low thermal expansion of the sealing material formed by using the sealing resin composition, and more effectively improving moisture resistance reliability and reflow resistance of the obtained semiconductor device, the content of the inorganic filler (D) in the sealing resin composition is preferably 50% by mass or more, more preferably 60% by mass or more, and still more preferably 65% by mass or more with respect to the entire sealing resin composition.

In addition, from the viewpoint of more effectively improving fluidity and fillability of the sealing resin composition during molding, the content of the inorganic filler (D) in the sealing resin composition may be, for example, 97% by mass or less, preferably 95% by mass or less and more preferably 90% by mass or less with respect to the entire sealing resin composition.

### [Other components]

The sealing resin composition according to the present embodiment may include components other than the above-described components, and for example, various additives such as a silane coupling agent, a fluidity imparting agent, a mold release agent, an ion scavenger, a low stress component, a flame retardant, a coloring agent, and an antioxidant can be appropriately blended.

### <Sealing resin composition>

The sealing resin composition according to the present embodiment is solid at normal temperature (25°C), a form thereof can be selected according to a molding method of the sealing resin composition, and the like, and examples thereof include particles such as tablet, powder, and granule; and sheets.

In addition, with regard to a method for producing the sealing resin composition, for example, the sealing resin composition can be obtained by a method in which each of the above-described components is mixed by a known unit, further melt-kneaded by a kneading machine such as a roll, a kneader, and an extruder, cooled, and pulverized. In addition, after pulverization, the sealing resin composition in a form of particles or sheets may be obtained by molding. For example, a particle-form sealing resin composition may be obtained by tablet-molding into a tablet. In addition, for example, a sheet-form sealing resin composition may be obtained by a vacuum extruder. In addition, dispersity, fluidity, and the like of the obtained sealing resin composition may be adjusted as appropriate.

The sealing resin composition according to the present embodiment has excellent fluidity, and a spiral flow length measured under the following conditions is 100 cm or more and 250 cm or less, preferably 100 cm or more and 220 cm or less, more preferably 120 cm or more and 200 cm or less, and still more preferably 155 cm or more and 180 cm or less.

As a result, the sealing resin composition has excellent moldability.

### (Conditions)

A flow length measured by injecting the sealing resin composition into a spiral flow measurement mold according to EMMI-1-66 under conditions of a mold temperature of 175°C, an injection pressure of 6.9 MPa, and a curing time of 120 seconds is defined as the spiral flow length.

The sealing resin composition according to the present embodiment has excellent curability, and a gel time at 175°C is 10 seconds or more and 60 seconds or less, preferably 20 seconds or more and 50 seconds or less and more preferably 32 seconds or more and 45 seconds or less.

As a result, the sealing resin composition has excellent fillability, and generation of an unfilled portion can be suppressed.

The gel time can be measured by melting the resin composition on a hot plate heated to 175°C, and then measuring a time (gel time) until the resin composition becomes tack-free while kneading with a spatula.

In a case where the sealing resin composition according to the present embodiment is cured under the conditions of 175°C and 2 minutes, a bending strength of a cured product thereof at a room temperature of 25°C can be set to 80 MPa or more, preferably 100 MPa or more and more preferably 110 MPa or more. The upper limit value thereof is not particularly limited, but is 300 MPa or less.

In a case where the sealing resin composition according to the present embodiment is cured under the conditions of 175°C and 2 minutes, a bending elastic modulus of a cured product thereof at a room temperature of 25°C can be set to 10,000 MPa or more, preferably 12,000 MPa or more and more preferably 13,000 MPa or more. The upper limit value thereof is not particularly limited, but is 30,000 MPa or less.

In the sealing resin composition according to the present embodiment, since the bending strength or the bending elastic modulus of the above-described cured product obtained from the composition is within the above-described range, it is possible to provide a cured product having excellent mechanical strength.

In the present embodiment, the above-described characteristics can be controlled, for example, by appropriately selecting the type and blending amount of each component contained in the sealing resin composition, a method of preparing the sealing resin composition, and the like.

### <Cured product>

By curing the sealing resin composition according to the present embodiment, it is possible to obtain a cured product which is obtained from a plant-derived raw material and is friendly to the global environment. A degree of biomass of the cured body can be 5% or more and 95% or less.

### [Use]

The sealing resin composition according to the present embodiment can be used as a sealing material for various electronic components, and can be used as a sealing material for, for example, a circuit board on which an electronic component is mounted, a rotor core in which a magnet is fixed (see International Publication No. WO2012/029278 and the like), a stator core in which a coil or the like is insulated (see Japanese Laid-open Patent Publication NO. 2020-094092A and the like), an electronic control unit for a vehicle (see International Publication No. WO2016/139985 and the like), a semiconductor device, or the like.

The rotor core will be described. A permanent magnet is inserted into a hole portion provided in the rotor core, and the resin composition is filled between the hole portion and the permanent magnet, thereby fixing the permanent magnet to the rotor core. In the step of filling the resin composition, a tablet obtained by the method according to the embodiment of the present invention can be used. By using the tablet according to the embodiment of the present invention as a sealing material, it is possible to enlarge the rotor core and to perform multiple simultaneous productions.

The stator core will be described. The stator core has a plurality of teeth, and a coil is wound around the plurality of teeth. At this time, it is necessary to insulate the coil from the stator core, and insulation can be achieved by interposing the sealing resin composition therebetween. In the step of interposing the resin composition, the resin composition according to the embodiment of the present invention can be applied. By using the tablet according to the embodiment of the present invention as a sealing material, it is possible to enlarge the stator core and to perform multiple simultaneous productions.

The electronic control unit for a vehicle will be described. As electronic control unit for a vehicle, a product obtained by sealing a substrate on which an electronic component or the like is mounted, with the resin composition is investigated. In the step of sealing with the resin composition, the resin composition according to the embodiment of the present invention can be applied. By using the tablet according to the embodiment of the present invention as a sealing material, it is possible to enlarge the electronic control unit for a vehicle and to perform multiple simultaneous productions.

The semiconductor device will be described. In the semiconductor device, a semiconductor element is sealed by a cured product of the above-described resin composition for sealing according to the present embodiment. Specific examples of the semiconductor element include integrated circuits, large-scale integrated circuits, transistors, thyristors, diodes, and solid-state image sensors. The semiconductor element is preferably a so-called element which does not allow light to enter or exit, excluding optical semiconductor elements such as a light receiving element and a light emitting element (light emitting diode or the like).

A base material of the semiconductor device is, for example, a wiring substrate such as an interposer, or a lead frame. In addition, the semiconductor element is electrically connected to the base material by wire bonding, flip chip connection, or the like.

Examples of a semiconductor device obtained by sealing a semiconductor element by sealing molding using the sealing resin composition include mold array package (MAP), quad flat package (QFP), small outline package (SOP), chip size package (CSP), quad flat non-leaded package (QFN), small outline non-leaded package (SON), ball grid array (BGA), lead frame BGA (LF-BGA), flip chip BGA (FCBGA), molded array process BGA (MAPBGA), embedded wafer-level BGA (eWLB), Fan-In type eWLB, and Fan-out type eWLB.

Hereinafter, a more specific description will be given with reference to the drawings.

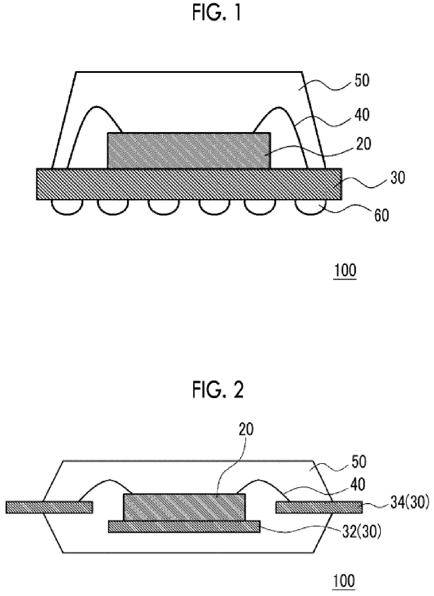

Figs. 1 and 2 are cross-sectional views showing configurations of the semiconductor device. In the present embodiment, the configuration of the semiconductor device is not limited to those shown in Figs. 1 and 2.

First, a semiconductor device 100 shown in Fig. 1 includes a semiconductor element 20 mounted on a substrate 30, and a sealing material 50 of sealing the semiconductor element 20.

The sealing material 50 is composed of a cured product obtained by curing the above-described sealing resin composition according to the present embodiment.

In addition, Fig. 1 shows a case where the substrate 30 is a circuit board. In this case, as shown in Fig. 1, for example, a plurality of solder balls 60 are formed on a surface of the substrate 30 on a side opposite to a surface on which the semiconductor element 20 is mounted. The semiconductor element 20 is mounted on the substrate 30 and is electrically connected to the substrate 30 through a wire 40. On the other hand, the semiconductor element 20 may be flip-chip mounted on the substrate 30. Here, the wire 40 is not limited, and examples thereof include Ag wire, Ni wire, Cu wire, Au wire, and Al wire. The wire 40 is preferably composed of Ag, Ni, Cu, or an alloy including one or more of these.

For example, the sealing material 50 seals the semiconductor element 20 to cover a surface of the semiconductor element 20 on a side opposite to a surface facing the substrate 30. In the example shown in Fig. 1, the sealing material 50 is formed to cover the above-described surface and a side surface of the semiconductor element 20.

In the present embodiment, the sealing material 50 is composed of a cured product of the above-described sealing resin composition. Therefore, in the semiconductor device 100, adhesiveness between the sealing material 50 and the wire 40 is excellent, and thus the semiconductor device 100 has excellent reliability.

For example, the sealing material 50 can be formed by sealing and molding the sealing resin composition with a known method such as a transfer molding method and a compression molding method.

Fig. 2 is a cross-sectional view showing a configuration of a semiconductor device 100 according to the present embodiment, and shows an example different from that of Fig. 1. The semiconductor device 100 shown in Fig. 2 uses a lead frame as the substrate 30. In this case, for example, the semiconductor element 20 is mounted on a die pad 32 of the substrate 30, and is electrically connected to an outer lead 34 through a wire 40. In addition, same as the example shown in Fig. 1, the sealing material 50 is composed of a cured product of the sealing resin composition according to the present embodiment.

The embodiments of the present invention have been described above, but these are examples of the present invention and various configurations other than the above can be adopted as long as the effects of the present invention are not impaired.

### [EXAMPLES]

Hereinafter, the present invention will be described in more detail by Examples, but the present invention is not limited thereto.

### [Synthesis Example 1]

### Synthesis of biomass-modified phenol resin (plant-derived phenolic curing agent (B1))

1500 parts by mass of phenol and 500 parts by mass of cashew oil (manufactured by TOHOKU CHEMICAL INDUSTRIES,LTD, LB-7000) were mixed with each other, 30 parts by mass of a boron trifluoride diethyl ether complex as an acid catalyst was added thereto, and the mixture was reacted at 120°C for 6 hours. Thereafter, 100 parts by mass of calcium hydroxide was added thereto to neutralize the mixture, and the mixture was filtered to remove the catalyst, thereby obtaining a reaction product containing a biomass derivative. 711 parts by mass of a 37% formalin aqueous solution was added to 2000 parts by mass of the obtained reaction product containing a biomass derivative and unreacted phenol, 20 parts by mass of formic acid as a catalyst was added thereto, and the mixture was reacted at 100°C for 2 hours. Subsequently, the reaction mixture was dehydrated by normal pressure distillation until the temperature of the reaction mixture reached 130°C. Thereafter, reduced pressure distillation was performed until the temperature of the reaction mixture reached 170°C in order to remove the unreacted phenol. Subsequently, steam was blown in at 0.9 kPa, and the unreacted phenol was distilled off and removed by steam distillation, thereby obtaining 1560 parts by mass of a biomass-modified phenol resin. A softening point of the obtained resin was 83°C, a content of free phenol was 0.1%, and a biomass content excluding the unreacted phenols was 31%. In addition, a proportion of a peak derived from alkyl chain unsaturated bond hydrogen, obtained from NMR, was 0.1% or less with respect to the total integrated value of peaks derived from hydrogens bonded to carbon atoms.

### [Comparative Example 1 and Examples 1 to 5]

Each component shown in Table 1 was mixed at a described ratio of amounts to obtain a mixture. The mixing was carried out at normal temperature using a Henschel mixer.

Thereafter, the mixture was roll-kneaded at 70°C to 100°C to obtain a kneaded product. The kneaded product thus obtained was cooled and then pulverized to obtain a sealing resin composition.

Each component shown in Table 1 is as follows.

### (Inorganic filler)

· Inorganic filler 1: molten spherical silica (manufactured by Denka Company Limited., product name: FB-950, average particle diameter D₅₀ = 24 µm)
· Inorganic filler 2: fumed silica (manufactured by Admatechs, product name: SO-C2, average particle diameter D₅₀ = 0.6 µm)
· Epoxy resin 1: cresol novolac-type epoxy resin (manufactured by DIC Corporation, EPICLON-N660)
· Epoxy resin 2: biphenyl-type epoxy resin (manufactured by Mitsubishi Chemical Corporation, YX4000)
· Epoxy resin 3: phenol aralkyl-type epoxy resin (manufactured by Nippon Kayaku Co., Ltd., NC-2000)
· Epoxy resin 4: biphenyl aralkyl-type epoxy resin (manufactured by Nippon Kayaku Co., Ltd., NC-3000)

### (Phenolic curing agent)

· Curing agent 1 (phenolic curing agent (B1)): novolac-type phenol resin (manufactured by Sumitomo Bakelite Co., Ltd., PR-HF-3)
· Curing agent 2 (phenolic curing agent (B2)): biomass-modified phenol resin obtained in Synthesis Example 1
· Curing accelerator: triphenylphosphine
· Silane coupling agent: N-phenylaminopropyltrimethoxysilane represented by Formula (S1) (manufactured by Dow Toray Company, Inc., CF-4083) 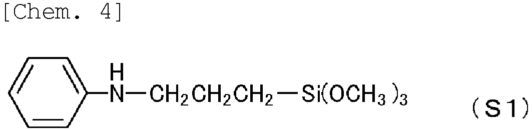
· Coloring agent: carbon black (manufactured by Tokai Carbon Co., Ltd.)
· Mold release agent: glycerin trimontanic acid ester (manufactured by Clariant Chemicals, Licolub)
. Ion scavenger: hydrotalcite (manufactured by Kyowa Chemical Industry Co., Ltd., DHA-4A)
· Low stress agent: epoxy/polyether-modified silicone oil (Dow Toray Company, Inc., FZ-3730)

### [Degree of biomass]

The biomass-modified phenol resin obtained in Synthesis Example 1 was subjected to measurement of peak values of C13 and C14 by C-NMR (JNM-ECA400 manufactured by JEOL Ltd.), and a biomass ratio of the phenol resin was calculated from the ratio thereof. From the values, a degree of biomass in the sealing resin and a biomass proportion in the organic components excluding the inorganic substance were calculated from the blending amount.

### [Spiral flow (SF)]

A spiral flow test was performed using the sealing resin compositions of Examples and Comparative Examples.

For the test, with a low-pressure transfer molding machine ("KTS-15" manufactured by KOHTAKI Corporation), the sealing resin composition was injected into a mold for measuring spiral flow according to EMMI-1-66 under conditions of a mold temperature of 175°C, an injection pressure of 6.9 MPa, and a curing time of 120 seconds, thereby measuring a flow length. As the numerical value is larger, the fluidity is better.

### [Gel time (GT)]

Each sealing resin composition of Examples and Comparative Examples was melted on a hot plate heated to 175°C, and a time (unit: seconds) until curing while kneading with a spatula was measured.

### [Evaluation of mechanical strength (bending strength and bending elastic modulus)]

The sealing resin composition was injection-molded into a mold using a low-pressure transfer molding machine ("KTS-30" manufactured by KOHTAKI Corporation) under the conditions of a mold temperature of 175°C, an injection pressure of 10.0 MPa, and a curing time of 120 seconds. As a result, a molded article having a width of 10 mm, a thickness of 4 mm, and a length of 80 mm was obtained. Next, the obtained molded article was post-cured under conditions of 175°C for 4 hours. In this manner, a test piece for evaluating a mechanical strength was produced. The bending strength (N/mm²) and the bending elastic modulus (N/mm²) of the test piece at normal temperature (25°C) were measured in accordance with JIS K 6911.

### [Electrical reliability]

The electrical reliability was evaluated by moisture resistance reliability (HAST) and high temperature storage characteristics (HTSL). The measurement methods are as follows.

Moisture resistance reliability (HAST): using a low-pressure transfer molding machine (manufactured by DAIICHISEIKO Co.,Ltd., GP-ELF), the epoxy resin composition was injected under the conditions of a mold temperature of 175°C, an injection pressure of 7.4 MPa, and a curing time of 105 seconds to seal-mold a lead frame and the like, on which a semiconductor element (silicon chip) was mounted, thereby producing a semiconductor device having a 16-pin SOP (standard product TEG9 for HAST was used as a semiconductor element, and the semiconductor element and the inner lead part of the lead frame were bonded to each other with a 25 pm-diameter gold wire); the obtained semiconductor device was subjected to a highly accelerated temperature and humidity stress test (HAST) in accordance with IEC 68-2-66; the test conditions were set to 130°C, 85 %RH, an applied voltage of 20 V, and a treatment for 240 hours; the presence or absence of an open failure of the circuit was observed for four terminals per one semiconductor device, and the number of defective circuits was measured by observing a total of 20 circuits with 5 semiconductor devices; a case in which the number of defects was 0 is indicated as ∘, and a case in which the number of defects was 1 to 5 is indicated as ×; the sealing resin compositions obtained in Comparative Example 1 and Examples 1 to 5 showed a favorable result that the number of defects was 0.

High temperature storage characteristics (HTSL): using a low-pressure transfer molding machine (manufactured by DAIICHISEIKO Co.,Ltd., GP-ELF), the resin composition for sealing a semiconductor was injected under the conditions of a mold temperature of 180°C, an injection pressure of 6.9 ± 0.17 MPa, and 90 seconds to seal-mold a lead frame and the like, on which a semiconductor element (silicon chip) was mounted, thereby producing a semiconductor device having a 16-pin dual inline package (DIP; 42 alloy lead frame, size: 7 mm × 11.5 mm × thickness 1.8 mm, size of the semiconductor element: 5 × 9 mm × thickness 0.35 mm; in the semiconductor element, an oxide layer with a thickness of 5 µm was formed and an aluminum wiring pattern with a line-and-space of 10 µm was formed thereon, the aluminum wiring pad portion and the lead frame pad portion on the element are bonded with a 25 µm-diameter gold wire); initial resistance values of 10 semiconductor devices were measured after being heat-treated at 175°C for 4 hours as a post-cure, and a high-temperature storage treatment at 175°C for 1,000 hours was performed; a resistance value of the semiconductor device after the high-temperature treatment was measured, a semiconductor device in which the resistance value was 130% of the initial resistance value was determined to be defective, a case in which the number of defective semiconductor devices was 0 is indicated as ∘, and a case in which the number of defective semiconductor devices was 1 to 10 was indicated as ×; the semiconductor devices obtained using the resin compositions for sealing a semiconductor of Comparative Example 1 and Examples 1 to 5 exhibited favorable reliability of 0/10.

### [Table 1]

**Table 1**

| | | | Comparative Example 1 | Example 1 |
|---|---|---|---|---|
| Inorganic filler 1 | | | 75.0 | 75.0 |
| Inorganic filler 2 | | | 5.0 | 5.0 |
| Epoxy resin 1 | | | 12.0 | 12.0 |
| Epoxy resin 2 | | | | |
| Epoxy resin 3 | | | | |
| Epoxy resin 4 | | | | |
| Phenolic curing agent 1 (derived from petroleum) | | Part by mass | 6.4 | 3.4 |
| Phenolic curing agent 2 (derived from plant) | | | | 3.0 |
| Curing accelerator | | | 0.2 | 0.2 |
| Silane coupling agent | | | 0.3 | 0.3 |
| Coloring agent | | | 0.3 | 0.3 |
| Mold release agent | | | 0.2 | 0.2 |
| Ion scavenger | | | 0.3 | 0.3 |
| Low stress agent | | | 0.3 | 0.3 |
| Total | | Part by mass | 100 | 100 |
| Degree of biomass | Biomass ratio of phenolic curing agent | % | 0 | 0.9 |
| | Biomass proportion in organic components | % | 0 | 4.6 |
| Fluidity | SF | cm | 150 | 160 |
| Curability | GT | sec | 30 | 33 |
| Mechanical properties | Bending strength (room temperature) | MPa | 130 | 125 |
| | Bending elastic modulus (room temperature) | MPa | 15000 | 14500 |
| Electrical reliability | HAST (130°C/85 %RH/20 V/240 h) | Judge | ○ | ○ |
| | HTSL (175°C/1000 h) | Judge | ○ | ○ |

**Table 1 (continued)**

| | | | Example 2 | Example 3 | Example 4 | Example 5 |
|---|---|---|---|---|---|---|
| Inorganic filler 1 | | | 75.0 | 75.0 | 75.0 | 75.0 |
| Inorganic filler 2 | | | 5.0 | 5.0 | 5.0 | 5.0 |
| Epoxy resin 1 | | | 12.0 | | | |
| Epoxy resin 2 | | | | 10.6 | | |
| Epoxy resin 3 | | | | | 11.7 | |
| Epoxy resin 4 | | | | | | 12.3 |
| Phenolic curing agent 1 (derived from petroleum) | | | | | | |
| Phenolic curing agent 2 (derived from plant) | | Part by mass | 6.4 | 7.8 | 6.7 | 6.1 |
| Curing accelerator | | | 0.2 | 0.2 | 0.2 | 0.2 |
| Silane coupling agent | | | 0.3 | 0.3 | 0.3 | 0.3 |
| Coloring agent | | | 0.3 | 0.3 | 0.3 | 0.3 |
| Mold release agent | | | 0.2 | 0.2 | 0.2 | 0.2 |
| Ion scavenger | | | 0.3 | 0.3 | 0.3 | 0.3 |
| Low stress agent | | | 0.3 | 0.3 | 0.3 | 0.3 |
| Total | | Part by mass | 100 | 100 | 100 | 100 |
| Degree of biomass | Biomass ratio of phenolic curing agent | % | 1.9 | 2.3 | 2.0 | 1.8 |
| | Biomass proportion in organic components | % | 9.7 | 11.9 | 10.2 | 9.3 |
| Fluidity | SF | cm | 170 | 220 | 180 | 190 |
| Curability | GT | sec | 35 | 45 | 40 | 40 |
| Mechanical properties | Bending strength (room temperature) | MPa | 122 | 115 | 120 | 118 |
| | Bending elastic modulus (room temperature) | MPa | 14300 | 14200 | 14200 | 14300 |
| Electrical reliability | HAST (130°C/85 %RH/20 V/240 h) | Judge | ○ | ○ | ○ | ○ |

As shown in Table 1, since the sealing resin composition of Examples according to the present invention contained the phenolic curing agent obtained from a plant-derived raw material, the sealing resin composition had excellent fluidity, and the cured product having excellent curability and electrical reliability was obtained. In addition, the curability and the mechanical properties were equivalent to those of a sealing resin composition containing only a phenolic curing agent derived from a petroleum in the related art. Furthermore, it is possible to provide a sealing resin composition which uses a plant-derived raw material and is friendly to the global environment, and a semiconductor device including a sealing material consisting of the composition.

Priority is claimed on Japanese Patent Application No. 2022-029262, filed February 28, 2022, the disclosure of which is incorporated herein by reference.

### REFERENCE SIGNS LIST

- 20: semiconductor element
- 30: substrate
- 32: die pad
- 34: outer lead
- 40: wire
- 50: sealing material
- 60: solder ball
- 100: semiconductor device

## Claims

1. A sealing resin composition comprising:
(A) an epoxy resin; and
(B) a curing agent including a phenolic curing agent obtained from a plant-derived raw material.

2. The sealing resin composition according to Claim 1,
wherein the phenolic curing agent obtained from a plant-derived raw material is a biomass-modified phenol resin which is modified with unsaturated carbon chain-containing phenols derived from a plant raw material.

3. The sealing resin composition according to Claim 1 or 2,
wherein the curing agent (B) includes a phenolic curing agent obtained from a petroleum-derived raw material.

4. The sealing resin composition according to any one of Claims 1 to 3,
wherein the epoxy resin (A) includes an epoxy resin obtained from a petroleum-derived raw material.

5. The sealing resin composition according to any one of Claims 1 to 4,
wherein the epoxy resin (A) includes an epoxy resin obtained by epoxidizing phenols derived from a plant-derived raw material.

6. The sealing resin composition according to any one of Claims 1 to 5, further comprising:
a curing accelerator (C).

7. The sealing resin composition according to any one of Claims 1 to 6, further comprising:
an inorganic filler (D).

8. The sealing resin composition according to any one of Claims 1 to 7,
wherein a spiral flow length measured under the following conditions is 100 cm or more and 250 cm or less,
(conditions)
a flow length measured by injecting the sealing resin composition into a spiral flow measurement mold according to EMMI-1-66 under conditions of a mold temperature of 175°C, an injection pressure of 6.9 MPa, and a curing time of 120 seconds is defined as the spiral flow length.

9. The sealing resin composition according to any one of Claims 1 to 8,
wherein a gel time at 175°C is 10 seconds or more and 60 seconds or less.

10. A cured product of the sealing resin composition according to any one of Claims 1 to 9.

11. The cured product according to Claim 10,
wherein a degree of biomass is 5% or more and 95% or less.

12. A semiconductor device comprising:
a semiconductor element; and
a sealing material which consists of the cured product according to Claim 10 or 11 and seals the semiconductor element.
